Europäisches Patentamt

European Patent Office

Office européen des brevets

(19)

(11) **EP 1 187 169 A2**

(12) **EUROPÄISCHE PATENTANMELDUNG**

(43) Veröffentlichungstag:
 **13.03.2002 Patentblatt 2002/11**

(51) Int Cl.⁷: **H01J 37/147**, H01J 37/141,
 H01J 37/30

(21) Anmeldenummer: **01121374.1**

(22) Anmeldetag: **06.09.2001**

(84) Benannte Vertragsstaaten:
 **AT BE CH CY DE DK ES FI FR GB GR IE IT LI LU
 MC NL PT SE TR**
 Benannte Erstreckungsstaaten:
 **AL LT LV MK RO SI**

(30) Priorität: **07.09.2000 DE 10044199**

(71) Anmelder:
 • **Carl Zeiss
 89518 Heidenheim (Brenz) (DE)**
 Benannte Vertragsstaaten:
 **DE FR IT NL**
 • **Carl-Zeiss-Stiftung, trading as Carl Zeiss
 89518 Heidenheim (Brenz) (DE)**
 Benannte Vertragsstaaten:
 **GB**

(72) Erfinder:
 • **Kienzle, Oliver, Dr.
 73430 Aalen (DE)**
 • **Weigand, Holger, Dr.
 73447 Oberkochen (DE)**

(74) Vertreter: **DIEHL GLAESER HILTL & PARTNER
 Patentanwälte
 Augustenstrasse 46
 80333 München (DE)**

(54) **Teilchenoptische Komponente und System mit teilchenoptischer Komponente**

(57) Es wird eine Magnetlinsenanordnung zur Bereitstellung eines magnetischen Ablenkfelds für einen Strahl geladener Teilchen vorgeschlagen, welche eine Fokussierlinseneinrichtung (17) zur Bereitstellung eines zu einer Symmetrieachse (19) der Anordnung im wesentlichen rotationssymmetrischen Magnetfelds, welches auf den dieses Magnetfeld durchsetzenden Strahl die Wirkung einer fokussierenden Linse (7) mit einer optischen Achse hat, und eine Achsverlagerungseinrichtung (31, 33) zur Bereitstellung eines dem von der Fokussierlinseneinrichtung (17) bereitgestellten Magnetfeld überlagerbaren Korrektur-Magnetfelds mit einer Wikung auf den Strahl derart, dass die optische Achse parallel zu der Symmetrieachse (19) der Anordnung verlagerbar ist. Die Magnetlinsenanordnung zeichnet sich dadurch aus, dass die Achsverlagerungseinrichtung (31, 33) einen ersten Satz (53) von konzentrisch zu der Symmetrieachse (19) und mit axialem Abstand voneinander angeordneten Ringen (55) aus einem elektrisch im wesentlichen nichtleitenden Material hoher magnetischer Permeabilität umfasst, wobei wenigstens eine Achsverlagerungswicklung (31, 33) mit einer Mehrzahl von Stromleiterwindungen zur Erzeugung des Korrektur-Magnetfelds vorgesehen ist, und wobei die Stromleiterwindungen der Achsverlagerungswicklung wenigstens einen der Ringe (55) des ersten Ringsatzes (53) umgreifen.

Fig. 2

**Beschreibung**

Die Erfindung betrifft eine teilchenoptische Komponente, welche einen Strahl geladener Teilchen abbildet oder ablenkt, und ein System, welches eine solche teilchenoptische Komponente umfasst.

Insbesondere betrifft die Erfindung eine Magnetlinsenanordnung, deren optische Achse bezüglich einer geometrischen Symmetrieachse der Anordnung verlagerbar ist. Ferner betrifft die Erfindung insbesondere ein Projektionssystem zur Übertragung eines auf einer Maske definierten Musters mittels eines Strahls geladener Teilchen auf ein teilchenempfindliches Substrat, insbesondere ein Elektronenstrahl-Projektionslithografiesystem.

Ferner betrifft die Erfindung auch insbesondere ein Elektronenmikroskopiesystem.

Aus dem Stand der Technik sind Magnetlinsenkonfigurationen bekannt, welche auf geladene Teilchen einer gegebenen Energie wie eine Linse mit einer Brennweite f wirken. D.h., mit einer solchen Magnetlinse kann ein paralleler Teilchenstrahl in einer mit einem Abstand f von der Linse angeordneten Bildebene fokussiert werden. Für zentral durch eine Symmetrieachse der Magnetlinse verlaufende Strahlenbündel ist hierbei die Abbildungsqualität relativ gut. Verläuft ein abzubildendes Strahlenbündel allerdings dezentral durch die Magnetlinse, werden für bestimmte Anwendungen in der Praxis zu große Aberrationen bei der Abbildung in die Bildebene erzeugt.

In dem Artikel "MOL (Moving Objective Lens)" Optik 48 (1977), Seiten 255 ff. von E. Goto et al. wird vorgeschlagen, die optische Achse der Linse durch ein Korrekturmagnetfeld aus der Symmetrieachse der Linse derart herauszuverlagern, dass sie mit dem dezentralen Teilchenstrahl zusammenfällt.

Aus US 4,376,249 ist eine konkrete Realisierung für eine solche von E. Goto vorgeschlagene Linse offenbart und wird dort als "Variable Axis Lens" bezeichnet. Die dort offenbarte Magnetlinse weist zwei bezüglich einer geometrischen Symmetrieachse der Linse mit axialem Abstand voneinander angeordnete und zur Symmetrieachse nach radial innen hinweisende Polenden auf. Radial innerhalb dieser Polenden ist jeweils eine Magnetanordnung zur Erzeugung eines Magnetfelds derart vorgesehen, dass die optische Achse aus der Symmetrieachse heraus verlagerbar ist. Längen und Durchmesser von zugehörigen Spulen sind so bemessen, dass diese ein Magnetfeld transversal zur Symmetrieachse von einer Größe erzeugen, welche proportional zur ersten Ableitung der Axialkomponente des Magnetfelds der Linse entlang der Symmetrieachse ist.

Es hat sich gezeigt, dass die aus US 4,376,249 bekannte herkömmliche Anordnung bei gewissen Anwendungen nicht die erforderliche Präzision aufweist.

Aus EP 0 969 326 A2, deren Inhalt durch Inbezugnahme hier voll umfänglich in die Beschreibung einbezogen wird, ist ein Lithografiegerät bekannt, welches ein auf einer Maske definiertes Muster mittels eines Elektronen-Projektionssystems auf ein strahlungsempfindliches Substrat überträgt. Hierbei wird die Maske mittels eines Elektronenstrahls eines wohldefinierten Strahlquerschnitts streifenweise abgetastet, wobei ein die Maske ungestreut durchsetzender Teil des Strahls auf das Substrat ebenfalls streifenweise abgebildet wird. Um eine ausreichende Belichtungsqualität zu gewährleisten, ist es notwendig, dass der Strahlquerschnitt in der Maskenebene mit einer ausreichenden Genauigkeit definiert ist. Ist dies nicht der Fall, resultiert daraus eine stellenweise Unter- oder Überbelichtung auf dem Substrat.

Es hat sich gezeigt, dass aus dem Stand der Technik bekannte Vorrichtungen diesbezüglich Verbesserungsbedarf aufweisen.

Es ist eine Aufgabe der vorliegenden Erfindung, eine Magnetlinsenanordnung vorzuschlagen, welche bezüglich einer Symmetrieachse der Anordnung versetzte Strahlen geladener Teilchen mit erhöhter Präzision handhaben kann.

Insbesondere ist es eine Aufgabe der Erfindung, eine Magnetlinsenanordnung vorzuschlagen, deren optische Achse aus deren Symmetrieachse heraus verlagerbar ist.

Ferner ist es eine Aufgabe der Erfindung, eine Ablenkanordnung vorzuschlagen, um einen Strahl geladener Teilchen in Strahlrichtung seitlich zu versetzen bzw. einen seitlich versetzten Strahl zu handhaben.

Eine weitere Aufgabe der Erfindung ist es, ein Projektionssystem zur Übertragung eines auf einer Maske definierten Musters mittels eines Strahls geladener Teilchen auf ein strahlungsempfindliches Substrat vorzuschlagen.

Ferner ist es eine weitere Aufgabe der Erfindung, ein Elektronenmikroskopiesystem zur elektronenmikroskopischen Untersuchung einer Probe vorzuschlagen.

Gemäß einem ersten Aspekt betrifft die Erfindung eine Ablenkanordnung für einen Strahl geladener Teilchen derart, dass ein Strahlquerschnitt von einer Objektebene der Anordnung in eine Bildebene übertragen wird, wobei in Projektion in Strahlrichtung die Strahlquerschnitte in Objektebene und Bildebene quer zur Strahlrichtung relativ zueinander verlagerbar sind.

Hierzu umfasst die Ablenkanordnung ein Magnetlinsen-Doublett aus zwei Magnetlinsen. Hierbei sind die beiden Magnetlinsen relativ zueinander derart angeordnet, dass ein Objekt, wenn es in einer vorderen Fokalebene der ersten Linse, welche auch Kollimatorlinse genannt wird, angeordnet ist, nach unendlich abgebildet wird. Die auch Projektionslinse genannte zweite Magnetlinse ist derart angeordnet, dass ihre vordere Fokalebene mit der hinteren Fokalebene der ersten Magnetlinse zusammenfällt. Die zweite Magnetlinse fokussiert deshalb den von der ersten Magnetlinse kollimierten Strahl in deren hintere Fokalebene, welche somit die Bildebene für das Doublett ist. Eine Vergrößerung des Magnetlinsen-Doubletts ist durch das Verhältnis der Fokallängen f1 und f2 der ersten bzw. zweiten Magnetlinse gegeben. Ferner entspricht der Abstand zwischen Objekt und Bildebene dem Doppelten der Summe der beiden Fokallängen f1 und f2.

Die beiden Magnetlinsen sind bezüglich einer Symmetrieebene "symmetrisch", welche von der Objektebene einen Abstand aufweist, der der doppelten Brennweite der ersten Magnetlinse entspricht, und welche von der Bildebene einen Abstand aufweist, der der doppelten Fokallänge der zweiten Magnetlinse entspricht. Die beiden Magnetlinsen sind zu der Symmetrieebene nicht in strengem mathematischen Sinn symmetrisch, sondern in Bezug auf einen Strahlengang durch die Linsen, und zwar unter Berücksichtigung der Vergrößerung. So skalieren die Größen der Linsen beispielsweise mit deren Fokallängen. Ströme bzw. Magnetfelder durch deren Spulen wiederum sind vom Betrag her gleich und insbesondere erzeugen diese Ströme entgegengesetzt gerichtete Magnetfelder, was dann als "antisymmetrisches Doublett" bezeichnet wird.

Erfindungsgemäß ist zwischen der ersten und der zweiten Magnetlinse eine Strahlverlagerungsanordnung vorgesehen, die ein solches Magnetfeld bereitstellt, dass ein in die Strahlverlagerungsanordnung eintretender Strahl aus der Strahlverlagerungsanordnung zu seiner ursprünglichen Strahlrichtung parallel versetzt wieder austritt.

Diese Strahlverlagerungsanordnung ist vorzugsweise im mathematischen Sinne symmetrisch zu der Symmetrieebene des Doubletts angeordnet, wobei Komponenten der Strahlverlagerungsanordnung bezüglich dieser Symmetrieebene ebenfalls geometrisch symmetrisch angeordnet sind. Diese bevorzugte Plazierung der Strahlverlagerungsanordnung im Bereich der Symmetrieebene des Doubletts führt dazu, dass sämtliche das Doublett durchsetzende Teilstrahlen im Wesentlichen den gleichen lateralen Versatz erfahren, da das Doublett in der Symmetrieebene einen Kreuzungspunkt (englisch: "Crossover") aufweist.

Durch die im Bereich der Symmetrieebene vorgesehe Strahlverlagerungsanordnung ist das Magnetlinsen-Doublett in der Lage, Strahlen zu handhaben, welche bezüglich einer (geometrischen) Symmetrieachse der Magnetlinsen einen Versatz aufweisen. So können beispielsweise bezüglich der Symmetrieachse versetzt in die Strahlverlagerungsanordnung eintretende Strahlen auf die Symmetrieachse zurückgeführt werden, es können auf der Symmetrieachse in die Strahlverlagerungsanordnung eintretende Strahlen versetzt zur Symmetrieachse aus der Strahlverlagerungsanordnung austreten und von der zweiten Linse des Doubletts weiter abgebildet werden, oder es können versetzt in die Strahlverlagerungsanordnung eintretende Strahlen mit gleichem oder anderem Versatz wieder aus der Strahlverlagerungsanordnung austreten.

Soll beispielsweise ein Strahl bezüglich der Symmetrieachse versetzt aus der Ablenkanordnung austreten und durch die zweite Magnetlinse möglichst aberrationsfrei abgebildet werden, so weist diese zweite Fokussierlinse vorzugsweise eine Eigenschaft auf, welche im Stand der Technik als "Moving Objective Lens" oder "Variable Axis Lens" bezeichnet wird. Insbesondere weist die zweite Magnetlinse dabei eine Achsversatzeinrichtung auf, welche ein Korrektur-Magnetfeld bereitstellt, welches dem von der Magnetlinse des Doubletts erzeugten fokussierenden Magnetfeld überlagerbar ist. Die Wirkung des überlagerten Magnetfelds auf den versetzt zur Symmetrieachse in die Magnetlinse eintretenden Strahl ist hierbei derart, dass auch die optische Achse der fokussierenden Magnetlinse parallel zu der Symmetrieachse derselben verlagert ist.

Soll das Doublett auch Strahlen handhaben, welche zu der Symmetrieachse versetzt in die Ablenkanordnung eintreten, so weist vorzugsweise auch die erste Linse des Doubletts eine solche Achsverlagerungseinrichtung auf.

Die Ablenkanordnung ist vorzugsweise Teil eines Projektionssystems zur Übertragung eines auf einer Maske definierten Musters mittels eines Strahls geladener Teilchen auf ein strahlungsempfindliches Substrat. Ein solches Projektionssystem umfasst eine Quelle geladener Teilchen, eine Strahlformungsblende zur Formung eines Querschnitts des Teilchenstrahls, eine erste teilchenoptische Abbildungsvorrichtung zum Abbilden der Strahlformungsblende auf die Maske und eine zweite teilchenoptische Abbildungsvorrichtung zum Abbilden der Maske auf das Substrat. Hierbei umfasst vorzugsweise die erste teilchenoptische Abbildungsvorrichtung die erfindungsgemäße Ablenkanordnung, wobei die Strahlformungsblende in der Objektebene und die Maske in der Bildebene des Magnetlinsen-Doubletts angeordnet ist. Hierdurch ist es möglich, den durch die Strahlformungsblende definierten Strahlquerschnitt mit erhöhter Kantenschärfe, d.h. einem steilen Übergang von hoher Teilchenintensität innerhalb des Strahlquerschnitts zu einer Teilchenintensität von null außerhalb des Strahlquerschnitts zu schaffen.

Es ist ebenfalls bevorzugt, die Ablenkanordnung in einem Elektronenmikroskopiesystem einzusetzen, und dabei insbesondere in einem Scanning Electron Microscope ("SEM") und einem Transmissionselektronenmikroskop ("TEM"). Bei dem Scanning Electron Microscope werden von einer Elektronenquelle emittierte Elektronen auf eine in einem Probenhalter montierte Probe mittels einer Fokussieranordnung fokussiert, und Elektronen, die aufgrund einer Wechselwirkung der auf die Probe fokussierten Elektronen aus dieser austreten, werden von einem Detektor erfasst. Die Ablenkanordnung ist dann Teil der Fokussieranordnung und erlaubt es, unter Bereitstellung eines großen, von dem Elektronenstrahl abgetasteten Bereichs, d.h. eines großen beobachtbaren Bildfelds, den Elektronenstrahl präzise auf die Probe zu fokussieren.

Das Transmissionselektronenmikroskop umfasst eine Elektronenquelle zur großflächigen Beleuchtung einer in einem Probenhalter montierten Probe und einen ortsauflösenden Detektor, auf den Transmissionselektronen, welche aus der Probe austreten, mittels einer Linsenanordnung abgebildet werden. Hier ist die Ablenkanordnung Teil der Linsenanordnung und erlaubt es, die aus der Probe austretenden Elektronen aus einem beliebigen Teilfeld eines großen Bereichs mit guter Abbildungsqualität auf den ortsauflösenden Detektor abzubilden.

Gemäß einem zweiten Aspekt betrifft die Erfindung eine Magnetlinsenanordnung, welche im Stand der Technik als "Moving Objective Lens" bzw. als "Variable Axis Lens" bezeichnet wird. Eine solche Magnetlinsenanordnung umfasst insbesondere eine Fokussierlinseneinrichtung zur Bereitstellung eines zu einer Symmetrieachse der Anordnung im Wesentlichen rotationssymmetrischen Magnetfelds, welches auf dem dieses Magnetfeld durchsetzenden Strahl die Wirkung einer fokussierenden Linse mit einer optischen Achse hat, und die Magnetlinsenanordnung umfasst ferner vorzugsweise eine Achsverlagerungseinrichtung zur Erzeugung eines dem von der Fokussierlinseneinrichtung bereitgestellten Magnetfeld überlagerbaren Korrektur-Magnetfelds mit einer Wirkung auf den Strahl derart, dass die optische Achse parallel zu der Symmetrieachse der Anordnung verlagerbar ist. Hierdurch erfährt ein zu der (geometrischen) Symmetrieachse der Linse versetzt in diese eintretender Teilchenstrahl eine Fokussierwirkung wie ein zentral in die Linse eintretender Teilchenstrahl, weshalb Aberrationen auf Grund des dezentralen Eintritts in die Linse, weitgehend unterdrückt sind.

Erfindungsgemäß wird das Korrektur-Magnetfeld durch eine Achsverlagerungswicklung bereitgestellt, welche eine Mehrzahl von Stromleiterwindungen umfasst, die innerhalb des Magnetfelds der Fokussierlinseneinrichtung angeordnet sind. Hierbei ist es wesentlich, dass das sich bei zeitlicher Änderung der Achsverlagerung ebenfalls zeitlich ändernde Korrekturmagnetfeld das fokussierende Magnetfeld der Fokussierlinseneinrichtung nicht stört. Dies wird dadurch erreicht, dass innerhalb des Magnetfelds der Fokussierlinseneinrichtung ein erster Satz von konzentrisch zu der Symmetrieachse und mit axialem Abstand voneinander angeordneten Ringen aus einem elektrisch im Wesentlichen nicht leitenden Material hoher magnetischer Permeabilität angeordnet ist. Die Permeabilitätszahl $\mu_r$ dieses Materials ist vorzugsweise größer als 10, insbesondere größer als 100 und weiter bevorzugt größer als 1000. Der elektrische Widerstand des Materials beträgt vorzugsweise mehr als $10^3 \ \Omega/m$, vorzugsweise mehr als $10^6 \ \Omega/m$ und weiter bevorzugt mehr als $10^{10} \ \Omega/m$.

Vorzugsweise weisen die Ringe des ersten Satzes im wesentlichen gleiche Durchmesser auf und sind vorzugsweise auch mit gleichen Abständen voneinander angeordnet.

Der Satz Ringe aus hochpermeablem Material ist für radialsymmetrische und axialsymmetrische Magnetfeldkomponenten so weit transparent, dass das fokussierende Magnetfeld der Fokussierlinseneinrichtung innerhalb der Ringe an den Orten, die der Teilchenstrahl durchsetzt, mit hoher Qualität bereitgestellt ist. Die Stromleiterwindungen der Achsverlagerungswicklung umgreifen dabei jeweils einen Ring oder eine Mehrzahl von Ringen des Ringsatzes, wobei wiederum die hohe magnetische Permeabilität der Ringe dazu beiträgt, bei begrenzten Strömen in der Achsverlagerungswicklung ein Korrekturmagnetfeld ausreichender Größe zu erzielen.

Vorzugsweise umgreifen die Stromleiterwindungen der Achsverlagerungswicklung zwei oder drei oder mehr der Ringe.

Das Korrekturmagnetfeld ist vorzugsweise ein quer zur Symmetrieachse orientiertes magnetisches Dipolfeld, dessen zur Symmetrieachse transversale Komponente entlang der Symmetrieachse einen Verlauf aufweist, der angenähert proportional zu der ersten Ableitung der zur Symmetrieachse parallelen Komponente des Magnetfelds der Fokussierlinseneinrichtung ist. Ein solcher Feldverlauf des Korrekturmagnetfelds kann durch geeignete Dimensionierung der Ringe und der Achsverlagerungswicklung erreicht werden.

Vorzugsweise umfasst die Fokussierlinseneinrichtung zwei mit axialem Abstand voneinander angeordnete und zur Symmetrieachse radial hinweisende Polenden. Hierbei ist einem jeden Polende zugeordnet wenigstens eine radial innerhalb desselben angeordnete Achsverlagerungswicklung vorgesehen. Vorzugsweise ist einem jeden Polende eine einzige Achsverlagerungswicklung zugeordnet.

Vorzugsweise ist radial außerhalb der Ringe des ersten Ringsatzes ein zweiter Satz von Ringen aus elektrischem, im Wesentlichen nicht leitendem Material hoher magnetischer Permeabilität vorgesehen. Auch die Ringe des zweiten Ringsatzes sind konzentrisch zu der Symmetrieachse und mit axialem Abstand voneinander angeordnet. Die Ringe des zweiten Satzes dienen dazu, das von der Achsverlagerungswicklung erzeugte Korrekturmagnetfeld nach radial außen abzuschirmen, so dass dieses im Wesentlichen nicht auf die Fokussierlinseneinrichtung einwirken kann. Insbesondere wird hierdurch vermieden, dass ein von der Achsverlagerungwicklung erzeugtes Magnetfeld Wirbelströme in der Fokussierlinseneinrichtung induziert. Die Ringe des zweiten Ringsatzes sind aus dem gleichen oder einem ähnlichen Material gefertigt wie die Ringe des ersten Ringsatzes.

Die Magnetlinsenanordnung umfasst vorzugsweise eine Stigmatorwicklung zur Korrektur von Abbildungsfehlern, wobei Stromleiterwindungen der Stigmatorwicklung ebenfalls auf Ringe vorzugsweise des ersten Ringsatzes gewickelt sind. Die Stigmatorwicklung stellt ein magnetisches Quadrupolfeld bereit, dessen Wirkung auf die Fokussierlinseneinrichtung vorzugsweise ebenfalls durch radial außerhalb der Stigmatorwicklung angeordnete Ringe des zweiten Ringsatzes verringert wird.

Ferner umfasst die Magnetlinsenanordnung dynamische Fokusspulen mit Windungen, die die Symmetrieachse umgreifen. Diese Windungen sind vorzugsweise radial innerhalb der Stromleiterwindungen der Stigmatorwicklung oder/und radial innerhalb der Ringe des ersten Ringsatzes angeordnet.

Die Magnetlinsenanordnung wird vorzugsweise in einem Projektionssystem zur Übertragung eines auf einer Maske definierten Musters mittels eines Strahls geladener Teilchen auf ein teilchenempfindliches Substrat oder ein Elektronenmikroskopiesystem eingesetzt.

Die Erfindung wird nachfolgend anhand von Ausführungsbeispielen erläutert. Hierbei zeigt:

Figur 1 einen schematischen Aufbau einer erfindungsgemäßen Ablenkanordnung sowie einen schematischen Strahlengang hierdurch,

Figur 2 eine schematische Darstellung einer in der Ablenkanordnung der Figur 1 enthaltenen Magnetlinsenanordnung,

Figur 3a, 3b, 3c verschiedene Wicklungstypen einer in Figur 2 gezeigten Achsverlagerungseinrichtung,

Figur 4a, 4b, 4c eine Anordnung von Stromleiterwindungen der in Figur 2 gezeigten Achsverlagerungswicklung am Umfang von Ferritringen,

Figur 5 eine grafische Darstellung eines Verlaufs einer Axialkomponente eines durch eine Fokussierlinse der Ablenkanordnung der Figur 1 erzeugten Magnetfelds,

Figur 6 ein Funktionsschaltbild zur Ansteuerung der verschiedenen Wicklungen der Ablenkanordnung der Figur 1,

Figur 7 eine weitere schematische Darstellung der in Figur 1 gezeigten Ablenkanordnung mit einer Darstellung der Beleuchtung einer Strahlformungsblende,

Figur 8 eine schematische Detaildarstellung einer zwischen Magnetlinsen der Figur 1 angeordneten Strahlverlagerungsanordnung,

Figur 9 einen schematischen Aufbau einer weiteren Ausführungsform der erfindungsgemäßen Ablenkanordnung sowie einen schematischen Strahlengang hierdurch,

Figur 10 schematisch einen Aufbaus eines Elektronenmikroskops, in das eine weitere Ausführungsform der erfindungsgemäßen Ablenkanordnung integriert ist,

Figur 11 in ebenfalls schematischer Darstellung ein Elektronenmikroskop, in das noch eine weitere Ausführungsform der erfindungsgemäßen Ablenkanordnung integriert ist, und

Figur 12 noch ein weiteres Elektronenmikroskop, in welches ebenfalls Ausführungsformen der erfindungsgemäßen Ablenkanordnung integriert sind.

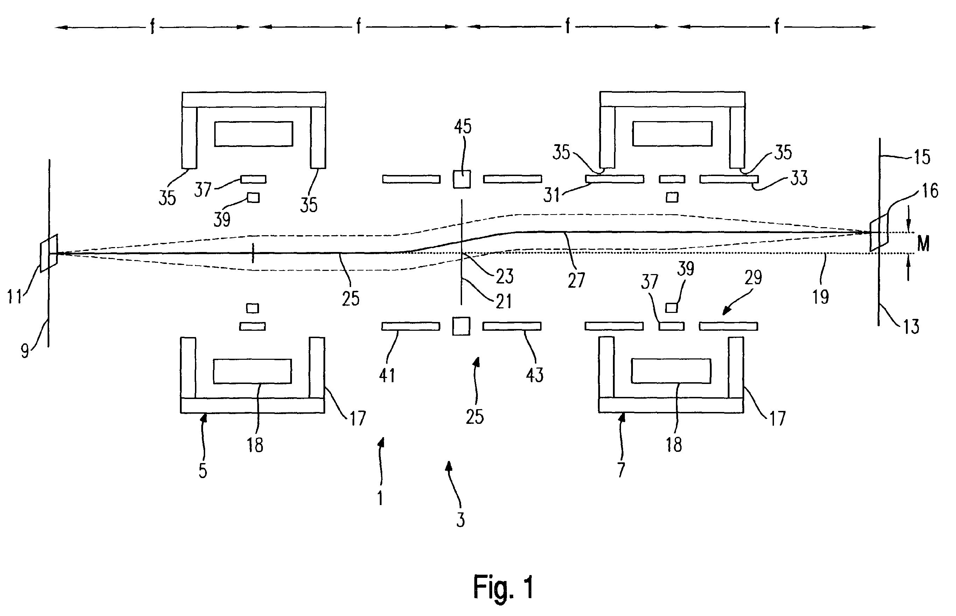

Figur 1 zeigt eine erfindungsgemäße Ablenkanordnung 1. Diese umfasst ein Magnetlinsen-Doublett 3 mit zwei Magnetlinsen 5 und 7, welche für Elektronen einer Energie von 100 keV jeweils eine Brennweite f von 180 mm aufweisen. Das Magnetlinsendoublett 3 dient zur Abbildung einer in einer Objektebene 9 des Doubletts 3 angeordneten Strahlformungsblende 11 auf eine in einer Bildebene 13 des Doubletts 3 angeordnete Maske 15. Hierbei definiert die Strahlformungsblende 11 auf der Maske 15 ein scharf umrissenes beleuchtetes Feld 16. Jede der Magnetlinsen 5 und 7 umfasst eine Wicklung 18 und Polschuhe 17, um jeweils ein fokussierendes Magnetfeld mit der Brennweite f bereitzustellen. Der Bohrungsdurchmesser der Pole beträgt 80 mm und der Polschuhspalt 40 mm.

Die Magnetlinsen 5 und 7 sind jeweils symmetrisch um eine Symmetrieachse 19 des Doubletts 3 und mit einem Abstand von 2 f voneinander angeordnet. Die Strahlformungsblende 11 ist mit ihrem Zentrum ebenfalls auf der Symmetrieachse 19 angeordnet.

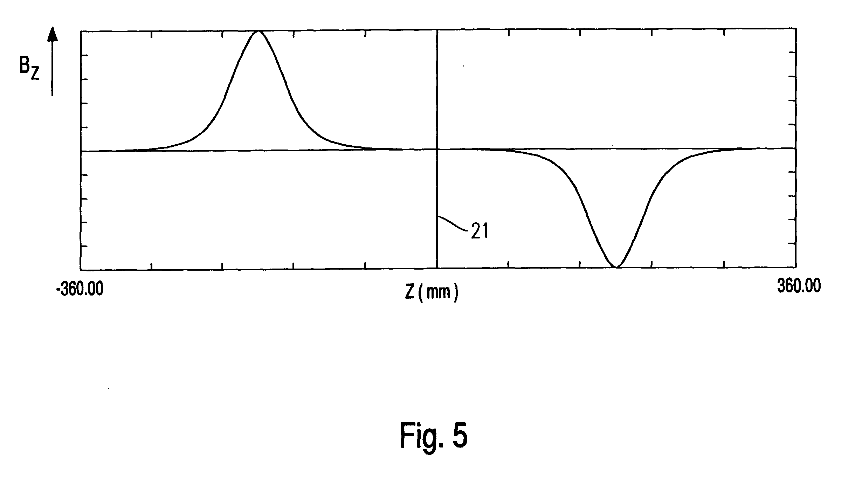

Der Verlauf der in Richtung der Symmetrieachse 19 gerichteten Axialkomponente $B_z$ des durch die Linsen 5 und 7 erzeugten Magnetfelds ist in Figur 5 in willkürlichen Einheiten dargestellt. Der Verlauf des Feldes ist dabei derart, dass in einer Symmetrieebene 21 des Doubletts 3 für einen das Doublett durchsetzenden Elektronenstrahl ein Crossover-Punkt 23 gebildet ist (antisymmetrisches Doublett).

Im Bereich der Symmetrieebene 21 ist ferner eine Ablenkeinrichtung 25 angeordnet, welche einen die Linse 5 zentral durchsetzenden Elektronenstrahl um einen Betrag M lateral zu der Symmetrieachse 19 versetzt. Der durch die Ablenkeinheit 25 um den Betrag M von der Symmetrieachse 19 versetzte Teilchenstrahl 27 tritt damit dezentral in die Linse 7 des Doubletts 3 ein, wobei sein Versatz um den Betrag M von der Symmetrieachse 19 beibehalten wird, so dass er ebenfalls um den Betrag M versetzt auf die Maske 15 trifft. Gleichwohl wird der Strahl 27 allerdings durch die Linse 7 auf die Bildebene 13 fokussiert. Das für diesen Zweck erforderliche Magnetfeld wird dadurch bereitgestellt, dass dem fokussierenden Feld der Linse 7, welches durch die Spule 15 und die Polschuhe 17 bereitgestellt wird, ein Korrekturmagnetfeld überlagert wird, welches durch eine Achsverlagerungseinrichtung 29 erzeugt wird. Die Achsverlagerungseinrichtung 29 umfasst zwei Ablenkwicklungen 31 und 33, welche jeweils radial innerhalb von nach radial innen zur Symmetrieachse 19 hinweisenden Enden 35 des Polschuhs 17 der Linse 7 angeordnet sind.

Die Ablenkwicklungen 31 und 33 stellen hierbei ein transversal zur Symmetrieachse 19 gerichtetes Magnetfeld bereit, dessen Größe proportional zur ersten Ableitung der in Figur 5 gezeigten Axialkomponente des durch die Linse 7 erzeugten Magnetfelds ist. Ein solcher Verlauf des Korrekturmagnetfelds ist durch geeignete Wahl der Geometrie für die Ablenkspulen 31 und 33 möglich.

Das Korrektur-Magnetfeld ist ferner proportional zu der Größe des durch die Strahlenverlagerungsanordnung erzeugten Achsversatzes M und zeigt in dessen Richtung.

Eine jede der Linsen 5 und 7 umfasst ferner eine Stigmatorwicklung 37 zur Korrektur eines astigmatischen Abbildungsfehlers der Linse 5 bzw. 7 sowie eine dynamische Fokusspule 39, um einen Fokusfehler der Bildfeldwölbung der Linse 5 bzw. 7 zu korrigieren.

Die Strahlenverlagerungsanordnung 25 umfasst zwei bezüglich der Symmetrieebene 21 symmetrische Ablenkspulen 41 und 43 sowie eine auf der Symmetrieachse 21 angeordnete weitere dynamische Fokusspule 45.

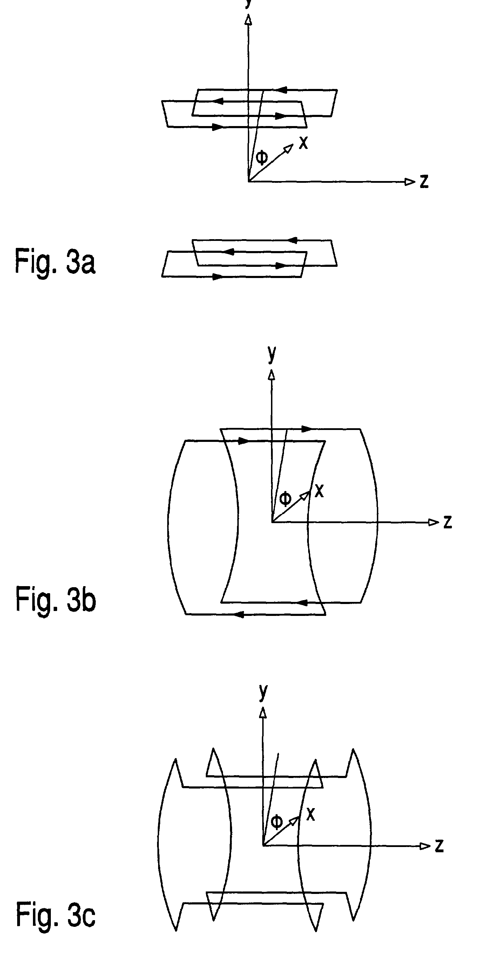

Mögliche Ausführungsformen für Windungen der Ablenkspulen 31, 33, 41 und 43 sind in Figur 3 schematisch dargestellt. Hierbei zeigt Figur 3a die Ausführung von Windungen als Toroid-Spule, Figur 3b die Ausführung als Sattelspule und Figur 3c die Ausführung als Verbund-Sattelspule.

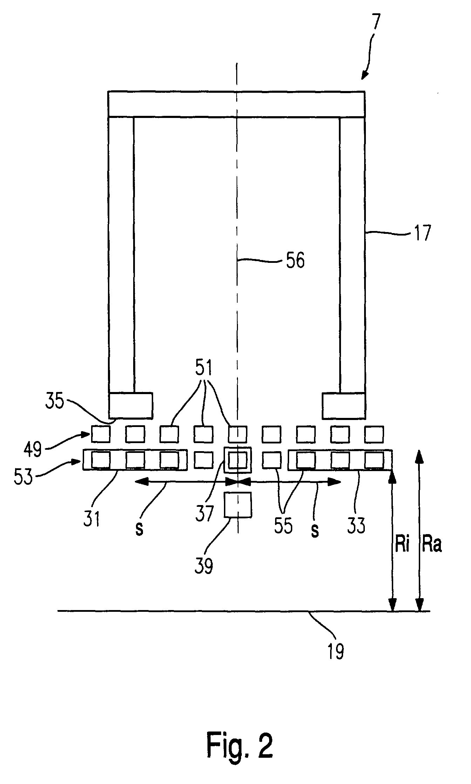

Wie aus Figur 2 ersichtlich ist, ist radial innerhalb der Polenden 35 der Pole 17 der Linse 7 ein Stapel 49 aus neun Ferritringen 51 gleichen Durchmessers äquidistant angeordnet. Radial innerhalb des Stapels 49 aus den Ferritringen 51 ist ein weiterer Stapel 53 aus ebenfalls neun Ferritringen 55 angeordnet, welche untereinander wiederum gleichen Durchmesser haben. Die Ferritringe 55 des inneren Satzes 53 weisen einen Innenradius Ri von 28 mm und einen Außenradius Ra von 32 mm auf.

Die Ablenkwicklungen 31 und 33 umgreifen hierbei die jeweils axial äußeren drei Ferritringe 55 des inneren Stapels 53, während die Stigmatorwicklung 37 den in Axialrichtung mittleren Ferritring 55 des Stapels 53 umgreift. Die dynamische Fokusspule 39 ist radial innerhalb des inneren Stapels 53 aus Ferritringen 55 angeordnet. Axiale Mittelpunkte der Spulen 31, 33 weisen von einer Symmetrieebene 56 der Linse 7 jeweils einen axialen Abstand s von 23 mm auf; die axiale Länge der Spulen 31 und 33 beträgt ebenfalls jeweils 24 mm.

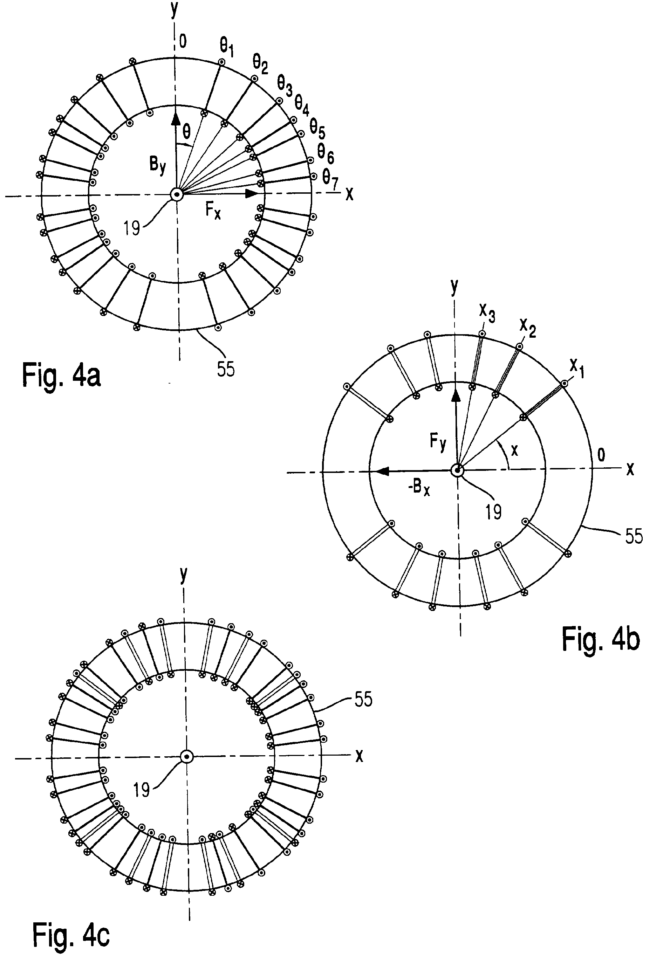

Die Verteilung der Windungen der Ablenkwicklungen 31 und 33 in Umfangsrichtung der Ferritringe 55 ist aus Figur 4 ersichtlich.

Figur 4a zeigt hierbei die Windungen, die zur Erzeugung eines in eine y-Richtung gerichteten magnetischen Dipolfelds By dienen, und Figur 4b zeigt Windungen, die zur Erzeugung eines hierzu orthogonalen Dipol-Feldes $B_x$ dienen. In Figur 4c ist die Kombination der in den Figuren 4a und 4b gezeigten Windungen auf den Ferritringen 55 dargestellt.

Um die beiden Linsen 5 und 7 möglichst symmetrisch zu gestalten, sind auch radial innerhalb von Polenden 35 der Linse 5 zwei in den Zeichnungen nicht dargestellte Stapel aus neun Ferritringen angeordnet, wie sie für die Linse 7 vorangehend erläutert wurden. Allerdings sind auf den radial inneren der beiden Stapel keine Ablenkspulen 31 und 33 gewickelt. Lediglich die Stigmatorspule 37 der Linse 5 ist auf den in Axialrichtung gesehen mittleren Ferritring des radial inneren Stapels der Linse 5 gewickelt.

Die Anordnung der Wicklungen 41 und 43 der Strahlenverlagerungsanordnung 25 ist aus Figur 8 im Detail ersichtlich. Die Strahlenverlagerungsanordnung 25 umfasst einen Satz 59 von 17 Ferritringen 61 gleichen Durchmessers, welche äquidistant in Axialrichtung und symmetrisch zur Symmetrieachse 21 angeordnet sind. Radial außerhalb eines jeden Ferritrings 61 ist ein Ferritring 63 größeren Durchmessers eines zweiten Satzes 65 von Ferritringen angeordnet. Die Ablenkspulen 41 und 43 sind hierbei auf Ferritringe 61 des radial inneren Satzes 59 gewickelt, wobei wiederum die in den Figuren 3a bis 3c dargestellten Windungsformen möglich sind. Die Verteilung in Umfangsrichtung um die Ferritringe 61 der Windungen entspricht wiederum der in der Figur 4 dargestellten Anordnung. Die Windungen der Ablenkwicklungen 41 und 43 umgreifen dabei die von axial außen gesehen zweiten bis sechsten Ferritringe 61.

Radial innerhalb des Stapels 59 von Ferritringen 61 ist die weitere Korrekturspule 45 angeordnet.

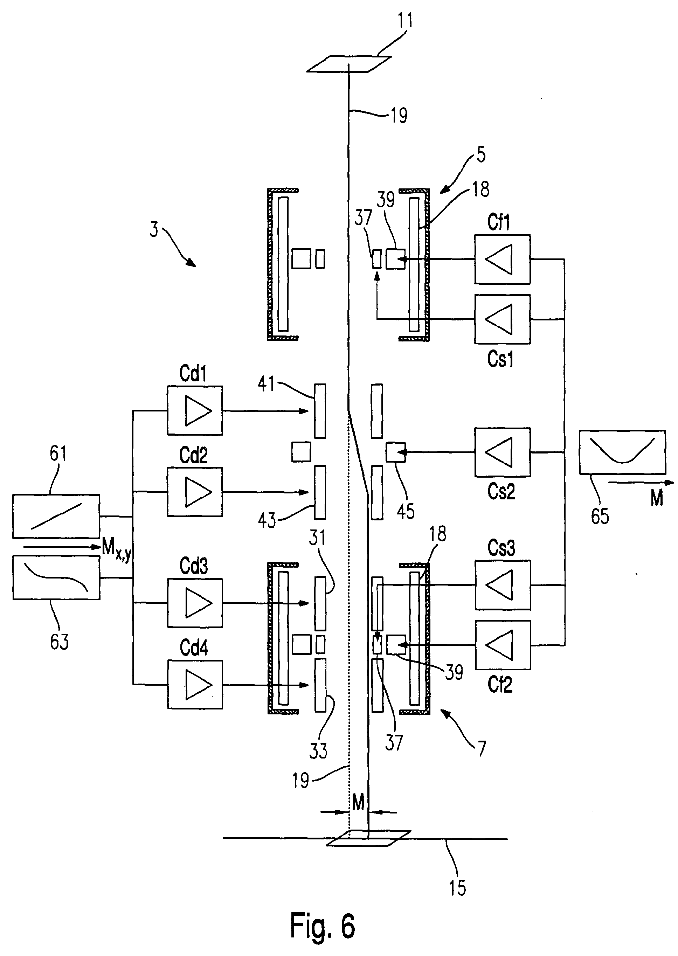

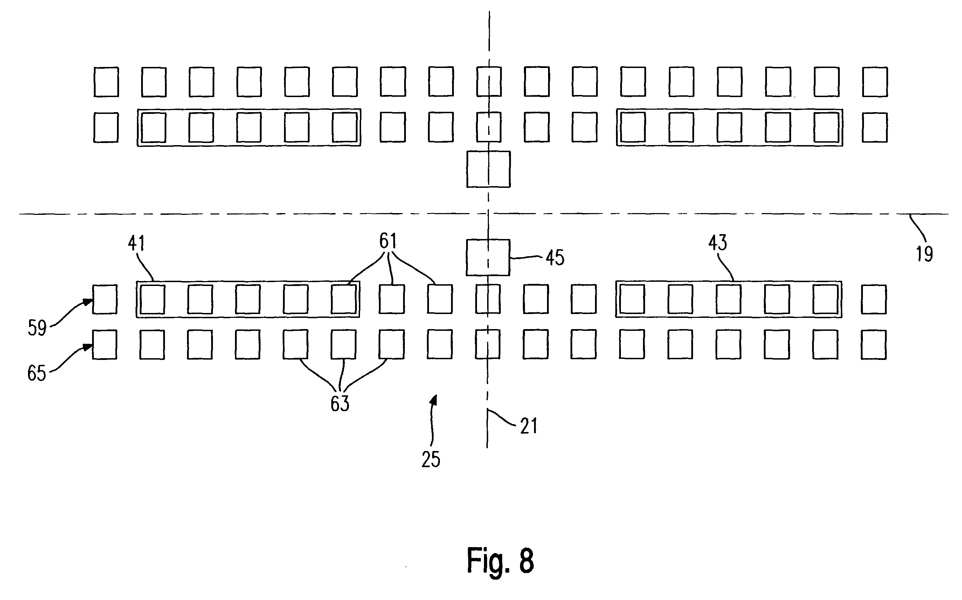

In Figur 6 ist ein Funktionsdiagramm zur Ansteuerung der einzelnen Wicklungen der in Figur 1 gezeigten Ablenkanordnung 1 erläutert. Die Wicklungen 18 der Linsen 5 und 7 des Doubletts 3 werden mit einem konstanten Strom angesteuert, so dass eine jede der Linsen 5 und 7 eine Brennweite f von 180 mm für die Elektronen bereitstellt. Um die Ablenkung M des Elektronenstrahls aus der Symmetrieachse 19 zu erzielen, werden die Ablenkspulen 41 und 43 der Strahlenverlagerungsanordnung 25 mit einem Strom angesteuert, der einen Proportionalanteil 61 aufweist, welcher proportional zu der Auslenkung M ist. Die Proportionalitätskonstanten sind hierbei mit Cd1 und Cd2 bezeichnet.

Um einen dem Versatz M des Strahls 27 entsprechenden Versatz der optischen Achse der Linse 7 zu erzeugen, werden die Spulen 31 und 33 der Linse 7 ebenfalls mit einem Strom angesteuert, der einen Proportionalanteil 61 aufweist, wobei die entsprechenden Proportionalitätskonstanten mit Cd3 und Cd4 bezeichnet sind. Um Verzeichnungsfehler zu vermeiden, haben die den Ablenkwicklungen 41, 43, 31 und 33 zugeführten Ströme weiterhin einen kubischen Anteil 63.

Die den Korrekturspulen 39, 45 sowie den Stigmatoren 37 zugeführten Ströme haben eine quadratische Abhängigkeit 65 von der Auslenkung M, wobei zugehörige Proportionalitätskonstanten mit Cf1, Cs1, Cf2, Cs2 und Cs3 bezeichnet sind.

Die Verhältnisse der Proportionalitätskonstanten Cd1, Cd2, Cd3 und Cd4 genügen bei idealer Einhaltung der Geometrie in der Fertigung der Anordnung vorzugsweise der Relation

$$|Cd1/Cd2| = |Cd3/Cd4| = 1.$$

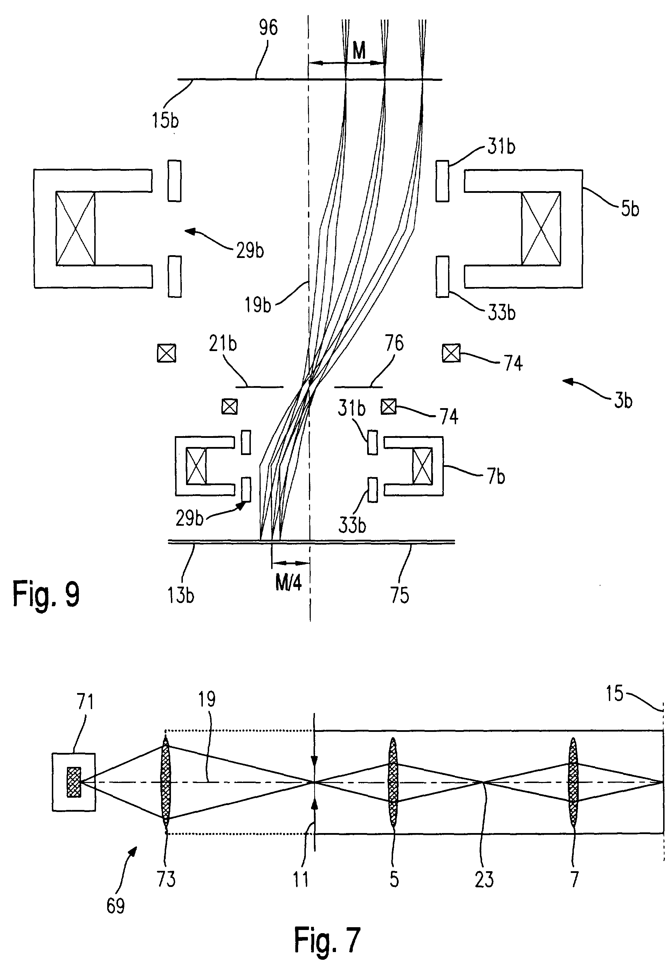

In Figur 7 ist schematisch ein Beleuchtungssystem 69 für die Strahlformungsblende 11 dargestellt, welche durch das Doublett 3 aus den fokussierenden Linsen 5 und 7 als beleuchtetes Feld 16 auf die Maske 15 abgebildet wird. Das Beleuchtungssystem 69 umfaßt eine Elektronenkanone 71 und eine fokussierende Magnetlinse 73, welche die von der Elektronenkanone 71 emittierten Elektronen so auf die Strahlformungsblende 11 lenkt, dass diese ausgeleuchtet ist.

Mit der beschriebenen Anordnung aus Linsen-Doublett 3, Strahlverlagerungsanordnung 25 und Achsverlagerungseinrichtung 29 ist es möglich, die Strahlformungsblende 11 mit sehr geringen Verzeichnungen auf ein beleuchtetes Feld 16 auf der Maske 15 abzubilden, wobei das beleuchtete Feld 16 aus der Symmetrieachse 19 herausverlagerbar ist. Eine Flankensteilheit (Anstieg der Intensität von 20 % auf 80 %) an den Rändern des beleuchteten Feldes 16 von 0,2 μm kann erzielt werden. Insbesondere durchsetzt der abbildende Strahl 25, 27 sowohl die Feldformungsblende 11 als auch die Maske 15 senkrecht (Telezentrie).

Die Ringsätze 49, 53, 59 und 65 können beispielsweise folgendermaßen gefertigt werden:

Es wird zunächst die gewünschte Anzahl von Ferritringen gleicher Innen- und Außendurchmesser und gleicher axialer Höhe hergestellt. Sodann wird eine entsprechende Anzahl von Keramikringen mit dem Durchmesser der Ferritringe und untereinander gleicher axialer Länge hergestellt. Abwechselnd werden Ferritringe und Keramikringe zum Stapel zusammengefügt. Es ist günstig, wenn das für die Keramikringe verwendete Material einen hohen spezifischen elektrischen Widerstand und eine magnetische Permeabilität nahe 1 aufweist. Beispielsweise kann die von der Firma Corning unter dem Markennamen Macor vertriebene Glaskeramik hierzu verwendet werden.

Im Folgenden werden Varianten der in den Figuren 1 bis 8 dargestellten Ablenkanordnung erläutert. Hinsichtlich ihres Aufbaus und ihrer Funktion einander entsprechende Komponenten sind mit den Bezugsziffern aus den Figuren 1 bis 8 bezeichnet, zur Unterscheidung jedoch mit einem zusätzlichen Buchstaben versehen. Zur Erläuterung wird auf die gesamte vorangehende Beschreibung Bezug genommen.

Figur 9 zeigt ein Magnetlinsen-Doublett 3b aus fokussierenden Magnetlinsen 5b und 7b. Das Doublett 3b dient dazu, eine in einer Objektebene 9b des Doubletts 3b angeordnete Maske 15b auf einen in einer Bildebene 13b des Doubletts angeordneten Halbleiter-Wafer 75 abzubilden. Für diese Abbildung wird ein Elektronenstrahl auf die Maske 15b gerichtet, wozu beispielsweise die in Figur 1 gezeigte Anordnung verwendet werden kann, welche mittels einer Strahlformungsblende ein wohl definiertes Feld auf der Maske 15b beleuchtet. Der Elektronenstrahl wird bezüglich einer Symmetrieachse 19b ausgelenkt, um das beleuchtete Feld gleichförmig und in Streifen über die Maske 15b zu bewegen. In Figur 9 ist der Strahlengang eines Zentralstrahls des beleuchteten Feldes für drei verschiedene Auslenkungsstellungen M dargestellt.

Das Doublett 3b bietet eine um den Faktor 1:4 verkleinernde Abbildung der Maske 15b auf dem Wafer 75. Hierzu sind die beiden Linsen 5b und 7b "symmetrisch" bezüglich einer Symmetrieebene 21b des Doubletts 3b. Die Symmetrie ist hier nicht im streng geometrischen Sinne zu verstehen, sondern unter Berücksichtigung der Verkleinerung 1:4, wobei auch die Größenverhältnisse der beiden Linsen 5b und 7b sowie deren Abstände zu der Symmetrieebene 21b wie 1:4 skalieren.

Zwischen den beiden Linsen 5b und 7b sind ferner zwei Ablenker 74 vorgesehen, die die Führung des Strahls in den in Fig. 9 gezeigten Strahlengang unterstützen.

In der Symmetrieebene 21b, an welcher ein Cross-Over-Punkt des Doubletts 3b gebildet ist, ist ferner eine Lochblende 76 angeordnet, so dass von der Maske 15b nur diejenigen Elektronen auf den Wafer 75 gelangen, welche von der Maske im Wesentlichen nicht gestreut wurden. Somit werden auf der Maske 15b als streuende Strukturen bereitgestellte Muster auf den Wafer 75 übertragen.

Da die Elektronenstrahlen um den Betrag M versetzt zur Symmetrieachse 19b in die Linse 5b eintreten, weist diese eine Achsverlagerungseinrichtung 29b mit zwei Achsverlagerungswicklungen 31b und 33b auf, so dass die optische Achse der Linse 5b derart aus der Symmetrieebene 19b herausverlagert wird, dass der Zentralstrahl des beleuchteten Feldes beim Durchtritt durch die Linse 5b mit der optischen Achse der Linse 5b zusammenfällt. Hierdurch bleibt die fokussierende Wirkung der Linse 5b auf die Teilstrahlen des beleuchteten Feldes erhalten, wobei allerdings aufgrund der Verlagerung der Strahlen aus der Symmetrieachse 19b hervorgerufene Aberrationen unterdrückt werden.

Aufgrund der verkleinernden Abbildung des Doubletts 3b treffen Strahlen, die in der Maskenebene 15b um den Betrag M von der Symmetrieachse 19b ausgelenkt sind, mit einer Auslenkung M:4 auf den Wafer 75. Somit durchsetzen die Strahlen auch die Linse 7b des Doubletts nicht zentral, und auch die Linse 7b weist eine Achsverlagerungseinrichtung 29b mit zwei Achsverlagerungswicklungen 31b und 33b auf, um die optische Achse der Linse 7b so aus der Symmetrieachse 19b herauszuverlagern, dass diese mit den Zentralstrahlen der ausgelenkten Strahlenbündel zusammenfällt.

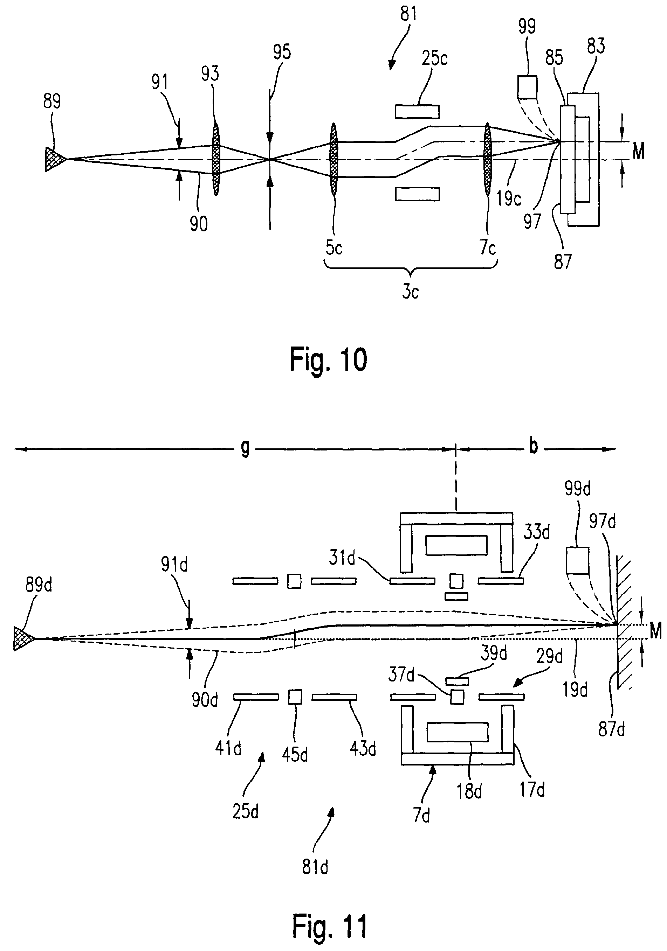

Figur 10 zeigt ein Elektronenmikroskopiesystem 81, welches als Scanning Electron Microscope arbeitet. Dieses umfasst einen Probenhalter 83 zur Aufnahme einer Probe 85 mit einer Probenoberfläche 87 derart, dass ein zu beobachtender Bereich der Probenoberfläche 87 bezüglich einer Hauptachse 19c des Mikroskops 81 zentriert ist. Eine Elektronenquelle 89 emittiert einen durch eine Aperturblende 91 begrenzten, divergierenden Elektronenstrahl 90, der von einer Linse 93 derart fokussiert wird, dass in der Ebene einer Streuelektronenblende 95 ein verkleinertes Abbild der Elektronenquelle 89 entsteht. Das verkleinerte Abbild der Elektronenquelle wird mittels eines Magnetlinsen-Doubletts 3c auf die Probenoberfläche 87 abgebildet, so dass dort im Bereich eines Punktes 97 ein möglichst kleiner Fleck der Probenoberfläche 87 beleuchtet wird. Die auf die Probenoberfläche 87 mit einer Energie von beispielsweise 20 keV auftretenden Elektronen der Elektronenquelle 89 erzeugen dort Sekundärelektronen, welche mittels eines Hilfsfeldes zu einem Elektronendetektor 99 hingezogen und von diesem registriert werden.

Das Magnetlinsen-Doublett 3c weist einen Aufbau auf, der im wesentlichen dem Aufbau des in Figur 1 gezeigten Magnetlinsen-Doubletts entspricht, und es ist hierbei ebenfalls eine Ablenkanordnung 25c vorgesehen, um den von den Elektronen beleuchteten Punkt 97 auf der Probenoberfläche 87 um einen änderbaren Betrag M aus der Symmetrieachse 19c auszulenken. Die Linse 7c weist hierbei ebenfalls eine in der Figur 10 nicht dargestellte Achsverlagerungseinrichtung auf, so dass auch bei vergleichsweise großen Auslenkwerten M des beleuchteten Punktes 97 von der Hauptachse 19c eine präzise und fein fokussierte Abbildung des verkleinerten Abbilds der Quelle 89 in der Ebene 95 und damit eine hohe Auflösung des Elektronenmikroskops 89 erzielbar ist.

Das Linsen-Doublett 3c kann ein symmetrisches Doublett sein, wobei die Linsen 5c und 7c gleiche Brennweiten aufweisen. Dies hat den Vorteil, dass sich gewisse Abbildungsfehler der Linsen 5c bzw. 7c kompensieren und ein besonders fein fokussiertes Bild der Quelle im wesentlichen unabhängig von der Auslenkung M auf der Probenoberfläche 87 erzeugbar ist. Der Einsatz des symmetrischen Magnetlinsen-Doubletts 3c zur Fokussierung ermöglicht hierbei insbesondere die Abbildung mit besonders geringem Koma-Fehler. Es kann das Doublett 3c allerdings auch unsymmetrisch aufgebaut sein, wobei die Brennweiten der Linsen 5c und 7c unterschiedlich sind. Auch hier kompensieren sich gewisse Abbildungsfehler der Linsen teilweise. Insbesondere hat dann die Linse 7c eine kleinere Brennweite als die Linse 5c, so dass eine weitere Verkleinerung des in der Ebene der Blende 95 erzeugten Bildes der Elektronenquelle 89 auf der Probenoberfläche 87 erzeugt wird.

Figur 11 zeigt eine Variante des in Figur 10 dargestellten Elektronenmikroskops. Das Elektronenmikroskop 81 der Figur 11 weist im Unterschied zu dem in Figur 10 gezeigten Mikroskop lediglich eine Fokussierlinse 7d auf, um einen von einer Elektronenquelle 89d emittierten und durch eine Aperturblende 91d geformten divergenten Strahl 90d auf eine Probenoberfläche 87d zu fokussieren. Die Fokussierlinse 7d ist, wie der zunächst von der Elektronenquelle 89d emittierte Strahl 90d, bezüglich einer Symmetrieachse 19d zentriert. Zwischen der Aperturblende 91d und der Fokussierlinse 7d ist eine Ablenkeinheit 25d vorgesehen, um den Strahl 90d um einen Betrag M parallel zur Symmetrieachse 19d zu versetzen. Die Ablenkeinrichtung 25d umfasst hierzu Ablenkspulen 41d und 43d sowie eine dynamische Fokusspule 45d.

Der um den Betrag M parallel von der Symmetrieachse 19d wegversetzte Elektronenstrahl tritt sodann in die Fokussierlinse 7d ein, welche eine Achsverlagerungseinrichtung 29d aufweist, um ebenfalls das Zentrum des von der Linse 7d bereitgestellten Ablenkfeldes in Übereinstimmung mit dem versetzten Elektronenstrahl um den Betrag M von der Symmetrieachse 19d wegzuversetzen. Damit hat die Linse 7d für den Strahl die Wirkung einer zentral durchsetzten Fokussierlinse, und ein Punkt 97d, an dem der Strahl fokussiert auf die Probenoberfläche 87d trifft, ist ebenfalls um den Betrag M bezüglich der Symmetrieachse 19d ausgelenkt. Ein Abstand g der Elektronenquelle 89d von der Fokussierlinse 7d ist größer gewählt als ein Abstand b der Probenoberfläche 87d von der Fokussierlinse 7d, so dass die Elektronenquelle 89d verkleinert in dem Bereich um den Punkt 97d auf die Probenoberfläche 87d abgebildet wird.

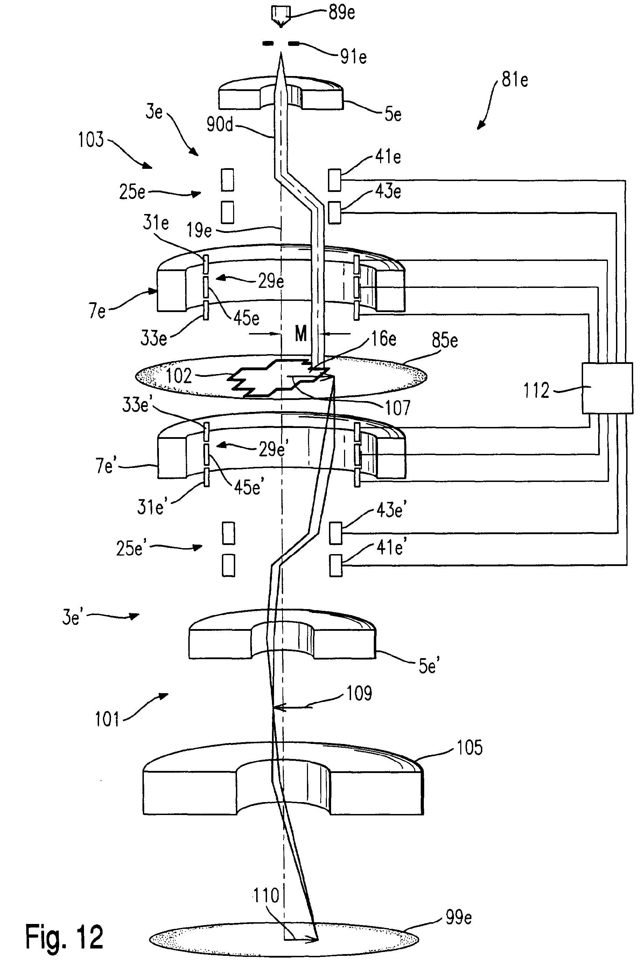

In Figur 12 ist ein Elektronenmikroskopiesystem 81e dargestellt, welches als Transmissionselektronenmikroskop arbeitet. Hierzu wird eine Probe 85e von ihrer einen Seite her in einem ausgedehnten Feld 16e mit Elektronen beleuchtet, und die in dem Feld 16e durch die Probe 85e hindurchtretenden Transmissionselektronen werden mittels einer Abbildungsoptik 101 auf einen ortsauflösenden Detektor 99e abgebildet. Das Objekt 85e ist hier eine Lithografiemaske zur Abbildung einer Struktur 102 auf einen Wafer in einem Lithografieprozess. Die Qualität der Struktur 102 wird mittels des Elektronenmikroskops 81e überprüft. Die Abbildungsoptik 101 ist dabei derart ausgebildet, dass das gesamte beleuchtete Feld 16e auf den Detektor 99e abgebildet wird. Ferner ist die Abbildungsoptik 101 dahingehend ausgebildet, dass das Feld 16e, welches auf den Detektor 99e abgebildet wird, aus einer Symmetrieachse 19e des Mikroskops 81e heraus um einen einstellbaren Betrag M verlagerbar ist. Somit können nach Änderung der Auslenkung M zeitlich nacheinander verschiedene Bereiche der Probe 85e auf den Detektor 99e abgebildet werden, so dass insgesamt ein vergleichsweise großer Bereich der Probe 85e untersucht werden kann, ohne diese relativ zu dem Mikroskop 81e mechanisch zu verlagern.

Ferner ist ein Beleuchtungssystem 103 zur Beleuchtung des auf dem Detektor 99e abgebildeten Bereichs 16e derart ausgebildet, dass nicht etwa die gesamte Probenoberfläche 85e gleichzeitig mit Elektronen beleuchtet wird, sondern lediglich der Bereich 16e, der zu einem Zeitpunkt auf dem Detektor 99e abgebildet wird. Die Beleuchtungsoptik 103 umfasst ein Fokussierlinsen-Doublett 3e mit Fokussierlinsen 5e und 7e, welche nacheinander von einem von einer Elektronenquelle 89e emittierten und einer Aperturblende 91e geformten Elektronenstrahl 90d durchlaufen werden. Zwischen den beiden Linsen 5e und 7e ist eine Ablenkeinheit 25e mit Ablenkspulen 41e und 43e vorgesehen, um den Strahl 90d um einen Betrag M von der Symmetrieachse 19e wegzuverlagern. Der von der Symmetrieachse 19e wegverlagerte Strahl 90d tritt sodann in die zweite Fokussierlinse 7e ein und wird von dieser derart auf die Probenoberfläche 85e gerichtet, dass dort lediglich der Bereich 16e beleuchtet wird, der ebenfalls um den Betrag M von der Symmetrieachse 19e wegverlagert ist. Die Fokussierlinse 7e umfasst hierzu eine Achsverlagerungseinrichtung 29e mit zwei Ablenkwicklungen 31e und 33e, wobei auch eine dynamische Fokusspule 45e vorgesehen ist.

Das Abbildungssystem 101 zur Abbildung der aus dem Bereich 16e austretenden Transemissionselektronen auf den Detektor 99e umfasst ein Linsen-Doublett 3e' sowie zur weiteren Nachvergrößerung eine Magnetlinse 105. Das Linsen-Doublett 3e' ist aus Komponenten aufgebaut, welche bezüglich der Probe 85e symmetrisch zu den Komponenten des Linsen-Doubletts 3e der Beleuchtungsoptik 103 angeordnet sind. Ferner ist zwischen Linsen 7e' und 5e' des Doubletts 3e' eine Ablenkeinheit 25e' vorgesehen, deren Komponenten ebenfalls bezüglich der Probe 85e symmetrisch zu den Komponenten der Ablenkeinheit 25e angeordnet sind. Die Komponenten des Linsen-Doubletts 3e' und der Ablenkeinheit 25e' der Abbildungsoptik 101 sind im Hinblick auf diese Symmetrie mit den gleichen Bezugszeichen wie die entsprechenden Komponenten der Beleuchtungsoptik 103 bezeichnet, zusätzlich jedoch mit einem Apostroph versehen. Die Abbildungsoptik 101 bildet eine Objektgröße 107 über ein Zwischenbild 109 in ein Bild 110 auf den Detektor 99e ab.

Mit dem Bezugszeichen 112 ist in Figur 12 eine Steuerung bezeichnet, welche Ströme in den Spulen 41e, 43e, 31e, 33e, 45e und 33e', 31e', 45e', 43e' und 41e' derart einstellt, dass sowohl die Beleuchtung des Feldes 16e als auch dessen Abbildung auf den Detektor 99e bei einer Auslenkung des Feldes 16e um den Betrag M weg von der Symmetrieachse 19e mit hoher Qualität erfolgt.

Alternativ zu der in Figur 12 gezeigten Transmissionselektronenmikroskopieanordnung ist es ebenfalls möglich, auf die gesteuerte Auslenkung des beleuchteten Feldes zu verzichten und einen Bereich der Probe gleichmäßig mit Elektronen zu beleuchten, der größer ist als der momentan auf den Detektor abgebildete Bereich. Dies vereinfacht den Aufbau und die Ansteuerung der Anordnung, kann dafür aber zu einer höheren thermischen Belastung der Probe führen.

**Patentansprüche**

1. Magnetlinsenanordnung zur Bereitstellung eines magnetischen Ablenkfelds für einen Strahl geladener Teilchen, umfassend:

   - eine Fokussierlinseneinrichtung (15, 17) zur Bereitstellung eines zu einer Symmetrieachse (19) der Anordnung im wesentlichen rotationssymmetrischen Magnetfelds, welches auf den dieses Magnetfeld durchsetzenden Strahl die Wirkung einer fokussierenden Linse (7) mit einer optischen Achse hat, und

   - eine Achsverlagerungseinrichtung (31, 33) zur Erzeugung eines dem von der Fokussierlinseneinrichtung (15, 17) bereitgestellten Magnetfeld überlagerbaren Korrekturmagnetfelds mit einer Wikung auf den Strahl derart, dass die optische Achse parallel zu der Symmetrieachse (19) der Anordnung verlagerbar ist,

   **dadurch gekennzeichnet, dass** die Achsverlagerungseinrichtung (29) einen ersten Satz (53) von konzentrisch zu der Symmetrieachse und mit axialem Abstand voneinander angeordneten Ringen (55) aus einem elektrisch im wesentlichen nichtleitenden Material hoher magnetischer Permeabilität umfasst, wobei wenigstens eine Achsverlagerungswicklung (31, 33) mit einer Mehrzahl von Stromleiterwindungen zur Erzeugung des Korrekturmagnetfelds vorgesehen ist, und wobei die Stromleiterwindungen der Achsverlagerungswicklung (31, 33) wenigstens einen der Ringe (55) des ersten Ringsatzes (53) umgreifen.

2. Magnetlinsenanordnung nach Anspruch 1, wobei eine zur Symmetrieachse transversale Komponente des Korrektur-Magnetfelds entlang der Symmetrieachse einen Verlauf aufweist, der jeweils angenähert proportional ist zu einer ersten Ableitung einer zur Symmetrieachse parallelen Komponente des von der Fokussierlinseneinrichtung bereitgestellten Magnetfelds entlang der Symmetrieachse.

3. Magnetlinsenanordnung nach Anspruch 1 oder 2, wobei die Fokussierlinseneinrichtung (15, 17) zwei mit axialem Abstand voneinander angeordnete und zur Symmetrieachse hinweisende Polenden (35) aufweist und wobei die Achsverlagerungseinrichtung (25) einem jeden Polende (35) zugeordnet eine zwischen Polende und Symmetrieachse angeordnete Achsverlagerungswicklung (31, 33) aufweist.

4. Magnetlinsenanordnung nach Anspruch 3, wobei einem jeden Polende (35) eine einzige Achsverlagerungswicklung (31, 33) zugeordnet ist.

5. Magnetlinsenanordnung nach Anspruch 3 oder 4, wobei die Achsverlagerungswicklung (31, 33) einen oder mehrere Ringe (55) des ersten Ringsatzes (53) umgreift.

6. Magnetlinsenanordnung nach einem der Ansprüche 1 bis 5, wobei radial ausserhalb der von der Achsverlagerungswicklung (31, 33) umgriffenen Ringe (55) des ersten Ringsatzes (53) eine Mehrzahl von Ringen (51) eines zweiten Ringsatzes (49) aus konzentrisch zu der Symmetrieachse und mit axialem Abstand voneinander angeordneten Ringen aus elektrisch im wesentlichen nichtleitendem Material hoher magnetischer Permeabilität vorgesehen ist.

7. Magnetlinsenanordnung nach einem der Ansprüche 1 bis 6, ferner umfassend wenigstens eine Stigmatorwicklung (37) mit mehreren Stromleiterwindungen, welche wenigstens einen der Ringe (55, 51) des ersten oder/und des zweiten Ringsatzes (53, 49) umgreifen.

8. Magnetlinsenanordnung nach Anspruch 7, wobei eine zwischen der Stigmatorwicklung (37) und der Symmetrieachse angeordnete dynamische Fokusspule (39) vorgesehen ist.

9. Magnetlinsenanordnung nach einem der Ansprüche 1 bis 7, wobei eine radial innerhalb der Ringe (55) des ersten Ringsatzes (53) angeordnete dynamische Fokusspule (39) vorgesehen ist.

10. Ablenkanordnung zur teilchenoptischen Abbildung eines ersten Querschnitts (11) eines Strahls geladener Teilchen in einer ersten Ebene (9) in einen zweiten Querschnitt des Strahls in einer zweiten Ebene (13), umfassend:

ein Magnetlinsen-Doublett (3) mit einer zwischen der ersten und der zweiten Ebene angeordneten ersten Fokussierlinse (5) und einer zwischen der ersten Fokussierlinse (5) und der zweiten Ebene (13) angeordneten zweiten Fokussierlinse (7), wobei die erste und die zweite Fokussierlinse auf einer gemeinsamen Symmetrieachse (19) angeordnet sind, wobei eine Symmetrieebene (21) des Doubletts (3) zwischen der ersten und der zweiten Fokussierlinse angeordnet ist, wobei ein Abstand zwischen der ersten Ebene (9) und der Symmetrieebene (21) der doppelten Brennweite (f) der ersten Fokussierlinse (5) entspricht, und wobei ein Abstand zwischen der zweiten Ebene (13) und der Symmetrieebene (21) der doppelten Brennweite (f) der zweiten Fokussierlinse (7) entspricht, und

eine zwischen der ersten und der zweiten Fokussierlinse angeordnete von dem Strahl durchsetzte Strahlverlagerungsanordnung (25) zur Erzeugung eines einstellbaren axialen Versatzes (M) zwischen dem in die Strahlverlagerungsanordnung (25) eintretenden und dem aus dieser austretenden Strahl,

wobei die erste oder/und die zweite Fokussierlinse eine Achsversatzeinrichtung zur Bereitstellung eines dem von der Fokussierlinse (5, 7) bereitgestellten Magnetfeld überlagerbaren Korrektur-Magnetfelds mit einer Wikung auf den Strahl derart aufweist, dass eine optische Achse der Fokussierlinse parallel zu deren Symmetrieachse (19) verlagerbar ist.

11. Ablenkanordnung nach Anspruch 10, wobei die Strahlverlagerungsanordnung (25) zwei bezüglich der Symmetrieebene symmetrisch angeordnete Ablenkeinheiten (41, 43) zur Bereitstellung jeweils eines Ablenk-Magnetfelds umfasst.

12. Ablenkanordnung nach Anspruch 11, wobei das Ablenk-Magnetfeld durch eine Ablenk-Wicklung (41) mit einer Mehrzahl von Stromleiterwindungen erzeugt ist, welche wenigstens einen konzentrisch zu der Symmetrieachse (19) angeordneten Ring (61) aus einem elektrisch im wesentlichen nichtleitenden Material hoher magnetischer Permeabilität umgreift.

13. Ablenkanordnung nach Anspruch 12, wobei ein dritter Satz (59) von konzentrisch zu der Symmetrieachse (19) und mit axialem Abstand voneinander angeordneten Ringen (61) aus dem elektrisch im wesentlichen nichtleitenden Material hoher magnetischer Permeabilität vorgesehen ist, wobei die Stromleiterwindungen der Ablenk-Wicklung (41) wenigstens einen der Ringe (61) des dritten Ringsatzes (59) umgreifen.

**14.** Ablenkanordnung nach Anspruch 13, wobei radial ausserhalb der von der Ablenk-Wicklung (41) umgriffenen Ringe (61) des dritten Ringsatzes (59) eine Magnetfeldabschirmung vorgesehen ist, die ein elektrisch im wesentlichen nichtleitendes Material hoher magnetischer Permeabilität umfasst.

**15.** Ablenkanordnung nach Anspruch 14, wobei die Magnetfeldabschirmung einen in Axialrichtung durchgehenden Zylinder oder eine Mehrzahl von konzentrisch zu der Symmetrieachse (19) und mit axialem Abstand voneinander angeordneten Ringen (63) eines vierten Ringsatzes (65) aus elektrisch im wesentlichen nichtleitendem Material hoher magnetischer Permeabilität umfasst.

**16.** Ablenkanordnung nach einem der Ansprüche 10 bis 15, wobei die erste oder/und die zweite Fokussierlinse (5, 7) eine Magnetlinsenanordnung nach einem der Ansprüche 1 bis 7 aufweist.

**17.** Projektionssystem zur Übertragung eines auf einer Maske definierten Musters mittels eines Strahls geladener Teilchen auf ein teilchenempfindliches Substrat, umfassend:

- eine Quelle geladener Teilchen,

- eine Strahlformungsblende zur Formung eines Querschnitts des Teilchenstrahls,

- eine erste teilchenoptische Abbildungsvorrichtung zum Abbilden der Strahlformungsblende auf die Maske,

- eine zweite teilchenoptische Abbildungsvorrichtung zum Abbilden der Maske auf das Substrat,

wobei die erste oder/und die zweite teilchenoptische Abbildungsvorrichtung eine Magnetlinsenanordnung nach einem der Ansprüche 1 bis 9 aufweisen.

**18.** Projektionssystem zur Übertragung eines auf einer Maske definierten Musters mittels eines Strahls geladener Teilchen auf ein teilchenempfindliches Substrat, umfassend:

- eine Quelle geladener Teilchen,

- eine Strahlformungsblende zur Formung eines Querschnitts des Teilchenstrahls,

- eine erste teilchenoptische Abbildungsvorrichtung zum Abbilden der Strahlformungsblende auf die Maske,

- eine zweite teilchenoptische Abbildungsvorrichtung zum Abbilden der Maske auf das Substrat,

wobei die erste oder/und die zweite teilchenoptische Abbildungsvorrichtung eine Ablenkanordnung nach einem der Ansprüche 10 bis 15 aufweist.

**19.** Projektionssystem nach Anspruch 18, wobei die Strahlformungsblende in der ersten Ebene des Magnetlinsen-Doubletts angeordnet ist und die Maske in der zweiten Ebene des Magnetlinsen-Doubletts angeordnet ist.

**20.** Projektionssystem nach Anspruch 18, wobei die Maske in der ersten Ebene des Magnetlinsen-Doubletts angeordnet ist und das Substrat in der zweiten Ebene des Magnetlinsen-Doubletts angeordnet ist.

**21.** Elektronenmikroskopiesystem, umfassend:

- einen Probenhalter zur Aufnahme einer zu untersuchenden Probe,

- eine Elektronenquelle,

- eine Fokussieranordnung, um von der Elektronenquelle emittierte Elektronen auf die Probe zu fokussieren, und

- einen Detektor, um Elektronen zu detektieren, die Aufgrund einer Wechselwirkung der auf die Probe fokussierten Elektronen aus dieser austreten,

wobei die Fokussieranordnung eine Magnetlinsenanordnung nach einem der Ansprüche 1 bis 9 umfaßt.

**22.** Elektronenmikroskopiesystem, umfassend:

- einen Probenhalter zur Aufnahme einer zu untersuchenden Probe,

- eine Elektronenquelle,

- eine Fokussieranordnung, um von der Elektronenquelle emittierte Elektronen auf die Probe zu fokussieren, und

- einen Detektor, um Elektronen zu detektieren, die Aufgrund einer Wechselwirkung der auf die Probe fokussierten Elektronen aus dieser austreten,

wobei die Fokussieranordnung eine Ablenkanordnung nach einem der Ansprüche 10 bis 15 aufweist.

**23.** Elektronenmikroskopiesystem, umfassend:

- einen Probenhalter zur Aufnahme einer zu untersuchenden Probe,

- eine Elektronenquelle zur Beleuchtung der Probe mit Elektronen,

- einen ortsauflösenden Detektor,

- eine Linsenanordnung, um Elektronen, die Aufgrund einer Wechselwirkung der auf die Probe fokussierten Elektronen aus dieser austreten, auf den ortsauflösenden Detektor abzubilden,

wobei die Linsenanordnung eine Magnetlinsenanordnung nach einem der Ansprüche 1 bis 9 aufweist.

**24.** Elektronenmikroskopiesystem, umfassend:

- einen Probenhalter zur Aufnahme einer zu untersuchenden Probe,

- eine Elektronenquelle zur Beleuchtung der Probe mit Elektronen,

- einen ortsauflösenden Detektor,

- eine Linsenanordnung, um Elektronen, die Aufgrund einer Wechselwirkung der auf die Probe fokussierten Elektronen aus dieser austreten, auf den ortsauflösenden Detektor abzubilden,

wobei die Linsenanordnung eine Ablenkanordnung nach einem der Ansprüche 10 bis 15 aufweist.

Fig. 1

EP 1 187 169 A2

Fig. 2

Fig. 3a

Fig. 3b

Fig. 3c

Fig. 4a

Fig. 4b

Fig. 4c

Fig. 5

EP 1 187 169 A2

Fig. 6

Fig. 8

EP 1 187 169 A2

Fig. 9

Fig. 7

Fig. 10

Fig. 11

Fig. 12